# EUROPEAN PATENT APPLICATION

(11) **EP 4 391 038 A1**
(43) Date of publication of application: **26.06.2024**
(21) Application number: 22214882.7
(22) Date of filing: 20.12.2022
(51) Int. Cl.: H01L 21/822, H01L 21/8238, H01L 27/06, H01L 27/092, H01L 29/06, H01L 29/775

(54) **A METHOD FOR FORMING A SEMICONDUCTOR DEVICE**

(71) Applicant: Imec VZW, 3001 Leuven (BE); Katholieke Universiteit Leuven KU Leuven Research & Development, 3000 Leuven (BE)
(72) Inventor: CHAN, Boon Teik, 3012 Wilsele (BE); LIU, Hsiao-Hsuan, 3001 Leuven (BE); SCHUDDINCK, Pieter, 9320 Nieuwerkerken (Aalst) (BE)
(74) Representative: AWA Sweden AB

(57) **Abstract**

The disclosure relates to a method for forming a semiconductor device, comprising:
forming, over a substrate, a stacked transistor structure comprising: a bottom channel structure and a top channel structure stacked on top of the bottom channel structure, a gate structure extending across the bottom and top channel structures, a first and a second bottom S/D structure on the bottom channel structure, and a first and a second top S/D structure on the top channel structure, wherein the first bottom and top S/D structures are formed at a first side of the gate structure, and the second bottom and top S/D structures are formed at a second side of the gate structure;
forming a first and a second bottom S/D contact on the first and the second bottom S/D structures;
forming a contact isolation layer capping the first and second bottom S/D contacts to form capped first and second bottom S/D contacts, and covering the capped first and second bottom S/D contacts with an ILD layer;
forming a first contact trench exposing the first top S/D structure over the capped first bottom S/D contact;
forming a second contact trench exposing the second bottom S/D contact and the second top S/D structure; and
forming a first top S/D contact in the first contact trench, in contact with the first top S/D structure, over the capped first bottom S/D contact, and a second top S/D contact in the second contact trench, in contact with the second top S/D structure and the second bottom S/D contact.

## Description

### Technical field

The present disclosure relates to a method for forming a semiconductor device.

### Background

In the strive to provide ever more area-efficient circuit designs, vertically stacked transistor devices are being developed. One notable example is the Complementary field-effect transistor (CFET) in which two horizontal channel transistors of complementary conductivity types are stacked on top of each other (e.g. a PFET bottom device and an NFET top device, or vice versa). The CFET allows a reduced footprint compared to a traditional side-by-side arrangement of a PFET and NFET. The two device levels provided by the CFET (e.g. a "2-level middle-of line / MOL") further enables a reduced routing layer usage in the back-end-of line (BEOL). The CFET is hence an enabler for area-efficient Complementary Metal-Oxide Semiconductor (CMOS) circuitry.

Using what may be referred to as a "monolithic" process, a CFET device may be formed by patterning a deposited stack of channel layers top-down to form channel layers (e.g. into the form of nanosheets) for both the bottom device and the top device. After processing source and drain bodies (e.g. by epitaxy) and forming source and drain contacts for the bottom and top devices, the channel layers of the bottom and top devices may be provided with a gate stack, also formed in "monolithic" process wherein the gate patterning for the top and bottom device is performed simultaneously. The CFET device may in particular be provided with a gate which is shared by, i.e. common to, the bottom and top devices.

The 2-level design of the CFET however introduces additional processing challenges related to source and drain contacting, due to the stacked arrangement of the bottom and top devices.

### Summary

An objective of the present inventive concept is to address the aforementioned challenge and provide a method addressing at least some challenges related to contacting of source/drains of stacked transistor devices (e.g. CFETs). Additional and alternative objectives may be understood from the following.

According to an aspect there is provided a method for forming a semiconductor device, comprising:
forming, over a substrate, a stacked transistor structure comprising: a bottom channel structure and a top channel structure stacked on top of the bottom channel structure, a gate structure extending across the bottom and top channel structures, a first and a second bottom source/drain (S/D) structure on the bottom channel structure, and a first and a second top S/D structure on the top channel structure, wherein the first bottom and top S/D structures are formed at a first side of the gate structure, and the second bottom and top S/D structures are formed at a second side of the gate structure opposite the first side;
forming a first and a second bottom S/D contact on the first and the second bottom S/D structures, respectively;
forming a contact isolation layer capping the first and second bottom S/D contacts to form capped first and second bottom S/D contacts, and covering the capped first and second bottom S/D contacts with an interlayer dielectric layer;
forming, at the first side of the gate structure, a first contact trench exposing the first top S/D structure over the capped first bottom S/D contact;
forming, at the second side of the gate structure, a second contact trench exposing the second bottom S/D contact and the second top S/D structure; and
forming a first top S/D contact in the first contact trench, in contact with the first top S/D structure, over the capped first bottom S/D contact, and a second top S/D contact in the second contact trench, in contact with the second top S/D structure and the second bottom S/D contact.

The present method provides an improved contacting approach for a stacked transistor structure (e.g. which may be suitable for a CFET). While the second contact trench is formed by opening the interlayer dielectric (ILD) layer and the contact isolation layer of the capped second bottom S/D contact, the first contact trench is formed by opening the ILD layer such that the contact isolation layer of the capped first bottom S/D contact is preserved. Hence, following the S/D top contact formation, the second bottom and top S/D structures at the second side of the gate structure are interconnected by the second bottom and top S/D contacts (formed in contact with each other), and the first bottom and top S/D structures at the first side of the gate structure are disconnected from each other as they are provided with first bottom and top S/D contacts spaced apart by the contact isolation layer capping the first bottom S/D contact.

Each one of the bottom and top channel structures may comprise a number of (i.e. one or more) (bottom/top) channel layers. In case a channel structure comprises of two or more channel layers, the two or more channel layers may be vertically stacked such that the channel structure comprises two or more vertically channel layers. Each (bottom/top) channel layer may be a (bottom/top) channel nanosheet. The term "nanosheet" as used herein refers to a layer of nanoscale dimensions.

Relative spatial terms such as "vertical", "upper", "lower", "top", "bottom", "above", "under", "underneath", "below", "down" are herein to be understood as denoting locations or orientations within a frame of reference of the substrate. In particular, the terms may be understood as locations or orientations along a normal direction to the substrate (i.e. a main plane of extension of the substrate). Correspondingly, terms such as "lateral" and "horizontal" are to be understood as locations or orientations parallel to the substrate (i.e. parallel to the main plane of extension of the substrate).

In some embodiments, the first contact trench may be formed while masking the ILD layer at the second side of the gate structure, and the second contact trench may be formed subsequent to the first contact trench, while masking the first contact trench and the ILD layer at the first side of the gate structure. This order of forming the first and second contact trenches allows forming the first and second contact trenches in a rational manner. By masking the first contact trench at the first side of the gate structure while forming the second contact trench, further deepening of the first contact trench (which potentially could expose the first bottom S/D contact) may be avoided. Additionally, exposure of the second bottom S/D contact to etching chemistries employed during the trench formation may be limited. By way of example, other than to the etching chemistry used when completing the first contact trench (i.e. when the contact isolation layer is opened), the second bottom S/D contact need only be exposed to the process chemistry for removing the mask used when forming of the first contact trench. As the first bottom S/D contact remains capped after forming the first contact trench, the first bottom S/D contact may remain masked from such process chemistry by at least the contact isolation layer capping the first bottom S/D contact.

While this order for forming the first and contact trenches may be advantageous, it is however also possible to form the contact trenches in the opposite order. That is, the second contact trench may be formed while masking the ILD layer at the first side of the gate structure, and the first contact trench may be formed subsequent to the second contact trench, while masking the ILD layer at the first side of the gate structure. In such an approach, masking of the first contact trench while forming the second contact trench may be optional, as the first contact trench already exposes the first bottom S/D contact.

In some embodiments, the first contact trench may be formed using a first lithography and etching process and the second contact trench may be formed using a second lithography and etching process. The first and second contact trenches may hence be sequentially formed (e.g. the first contact trench and then the second contact trench, or vice versa) using respective lithography and etching processes.

The first lithography and etching process may comprise patterning a first contact opening in a first hardmask layer formed over the stacked transistor structure, and opening the ILD layer by etching via the first contact opening.

The second lithography and etching process may comprise patterning a second contact opening in a second hardmask layer formed over the stacked transistor structure, and opening the ILD layer and the contact isolation layer of the capped second bottom S/D contact by etching via the second contact opening.

Presence of a hardmask layer may mitigate loss of material of the ILD layer during the respective etching processes of the contact trench formations. A hardmask layer may provide the additional benefit of an increased mask robustness and flexibility in terms of other masking materials of lithographic mask layer stacks ("litho-stacks") used in the lithography and etching processes. For instance, some etching chemistries which typically may be suitable for etching the ILD layer and the contact isolation layer may be incompatible with organic planarizing mask layers (e.g. organic spin-on layers such as spin-on-carbon) which typically are in litho-stacks (e.g. by causing delamination of the spin-on-carbon). Presence of a hardmask layer may reduce such a risk and/or provide the option of removing the lithographic layer stack after patterning the respective hardmask layer and prior to the contact trench formation, wherein the (first or second) hard mask layer on its own may be used as an etch mask while forming the (first or second) contact trenches.

In some embodiments, the first hardmask layer and the second hardmask layer may be a same hardmask layer. This reduces the number of process steps and additionally reduces the number of hardmask layer removal processes the ILD layer needs to be exposed to.

In some embodiments, forming the first and second top S/D contacts may comprise simultaneously depositing one or more metals in the first and the second contact trenches. This enables a rational contact formation approach by reducing the number of metal deposition steps needed. The one or more metals may more specifically be deposited to fill the first and second contact trenches. The forming of the first and second top S/D contacts may further comprise removing an overburden of the one or more metals using a planarization process. The first and second top S/D contacts may thereby be formed with a respective planar upper surface flush with an upper surface of the ILD layer.

In some embodiments, forming the second contact trench may comprise: opening the ILD layer using an anisotropic etching process to expose the contact isolation layer of the capped second bottom S/D contact, and thereafter etching the contact isolation layer of the capped second bottom S/D contact using an isotropic etching process, wherein the isotropic etching process removes a contact isolation layer portion (i.e. a portion of the contact isolation layer) remaining underneath the second top S/D structure after opening the interlayer dielectric layer.

The second contact trench formation may hence comprise two successive etch steps: a first anisotropic etching process extending through (e.g. top-down) the ILD layer, and a second isotropic etching process to open and/or remove the contact isolation portion underneath the second top S/D structure.

Employing an anisotropic etching process for the first etch step enables etching of a contact trench with a high-aspect ratio, while avoiding undercutting (e.g. which could unintentionally expose contact structures of adjacent transistor structures, if present). By employing an isotropic etching process for the second step of the formation of the second contact trench, the contact isolation layer may be efficiently removed from the second bottom S/D contact. In particular, the isotropic etching process allows the remaining contact isolation layer portion masked / shadowed by the second top S/D structure during the anisotropic etching process to be removed. This in turn enables an increased contact surface area between the second bottom and top S/D contacts.

The anisotropic etching process may be stopped on the contact isolation layer. In other words, the contact isolation layer may be used as an etch stop layer for the anisotropic etching process. Alternatively, the anisotropic etching process may be stopped on the second bottom S/D contact. In other words, the second bottom S/D contact (e.g. an upper metal surface thereof) may be used as an etch stop layer for the anisotropic etching process. The anisotropic etching process may accordingly comprise first etching through the ILD layer and then etching through the contact capping layer of the capped second bottom S/D contact. An advantage with etching through also the contact capping layer may be that less contact capping material needs to be removed by the isotropic etching process. The isotropic etching process may hence be of a shorter duration, wherein the exposure of the metal surface of the second bottom S/D contact to the isotropic etching process may be reduced.

The isotropic etching process may further remove an ILD layer portion (i.e. a portion of the ILD layer) remaining underneath the second top S/D structure after opening the ILD layer. This may enable a volume of the first top S/D contact to be increased. It may further enable the first top S/D contact to completely wrap-around the second top S/D structure (i.e. form a wrap-around contact for the second top S/D structure).

In some embodiments, the method may further comprise forming a non-stacked transistor structure comprising: a channel structure located at a same level over the substrate as the bottom channel structure of the stacked transistor structure, a further gate structure extending across the channel structure, and a first and a second S/D structure on the channel structure, wherein the first S/D structure is formed at a first side of the further gate structure, and the second S/D structure is formed at a second side of the further gate structure opposite the first side of the further gate structure and merges with the second bottom S/D structure of the stacked transistor structure;
wherein the method may further comprise:
forming a third bottom S/D contact on the first S/D structure of the non-stacked transistor structure;
forming the contact isolation layer to cap the third bottom S/D contact to form a third capped bottom S/D contact, and covering the third capped bottom S/D contact with the ILD layer; and
forming the second bottom S/D contact on the second S/D structure of the non-stacked transistor structure.

The second bottom S/D contact may hence define a common bottom S/D contact for the second bottom S/D structure of the stacked transistor structure and the second S/D structure of the non-stacked transistor structure, which subsequently may be interconnected with the second top S/D structure by the second top S/D contact. Accordingly, the second contact trench may be formed to expose the second bottom S/D contact on the second bottom S/D structure of the stacked transistor structure and on the second S/D structure of the non-stacked transistor structure, and the second top S/D structure.

By the term "non-stacked transistor structure" is hereby meant a transistor structure comprising only a single active channel structure. That is the non-stacked transistor structure does not comprise any channel structure located at a same level over the substrate as the top channel structure of the stacked transistor structure. A "non-stacked transistor structure" may also be understood in relation to process steps for forming the non-stacked transistor structure: That is, a "non-stacked transistor structure" may be a transistor structure formed by forming an initial stacked transistor structure comprising a bottom channel structure and a top channel structure stacked on top of the bottom channel structure, and thereafter removing the top channel structure or forming a cut through the top channel structure, such that the bottom channel structure remains (i.e. underneath the cut) to define the channel structure of the (non-stacked) transistor structure.

In some embodiments, the method may comprise forming, at the first side of the further gate structure, a third contact trench exposing the third S/D contact, simultaneous to forming the second contact trench; and
forming a third top S/D contact in the third contact trench, on the third bottom S/D contact.

The third top S/D contact facilitates access to the first S/D structure of the non-stacked transistor structure by stacking a third top S/D contact on top of the third bottom S/D contact. Forming the third contact trench simultaneous to the second contact trench, enables a rational contact formation approach by reducing the number of separate trench formation steps needed. In particular, the second and third second contact trench may be formed using a same second lithography and etching process.

In some embodiments, the first contact trench may be formed while masking the interlayer dielectric layer at the second side of the gate structure, and at the first and second sides of the further gate structure, and wherein the second and third contact trenches may be formed subsequent to the first contact trench, while masking the first contact trench and the interlayer dielectric layer at the first side of the gate structure.

In some embodiments, the first contact trench may be formed using a first lithography and etching process and the second and third contact trenches may be formed using a second lithography and etching process.

The first lithography and etching process may comprise patterning a first contact opening in a first hardmask layer formed over the stacked transistor structure, and opening the interlayer dielectric layer by etching via the first contact opening.

The second lithography and etching process may comprise patterning a second contact opening and a third contact opening in a second hardmask layer formed over the stacked transistor structure, and opening the interlayer dielectric layer and the contact isolation layer of the capped second bottom S/D contact by etching via the second contact opening, and opening the interlayer dielectric layer and the contact isolation layer of the third capped S/D contact by etching via the third contact opening.

The above discussion concerning the first and second hardmask layers applies correspondingly to this discussion.

In some embodiments, forming the first, second and third top S/D contacts may comprise simultaneously depositing one or more metals in the first, second and third contact trenches.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.

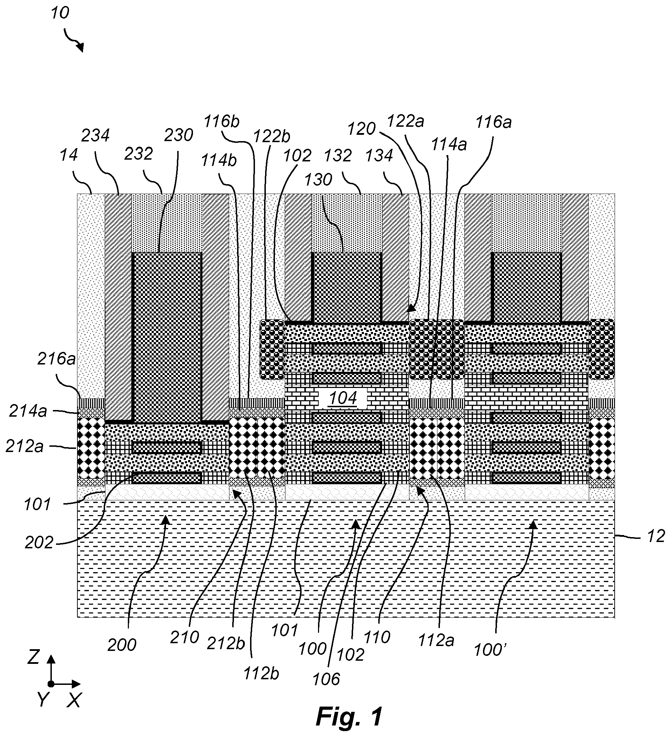

Fig. 1-9 illustrate steps of a method for forming a semiconductor device in accordance with an embodiment.

### Detailed description

An embodiment of a method forming a semiconductor device will now be described with reference an example device structure 10, as shown at various stages of the method in Fig. 1-9. The device structure 10 as shown comprises a stacked transistor structure 100 and a non-stacked transistor structure 200 adjacent the stacked transistor structure 100. While reference in the following will be made mainly to the transistor structures 100, 200, the device structure 10 may comprise further transistor structures, such as a further stacked transistor structure 100' as shown in the figures. As will become apparent from the figures, such further stacked transistor structure 100' may be processed in parallel and in a corresponding manner as the stacked transistor structure 100. It is furthermore to be noted that the method steps applied to the stacked transistor structure 100, as disclosed herein, are applicable to the stacked transistor structure 100, regardless of whether a non-stacked transistor structure is present in the device structure 10 or not.

Each one of Fig. 1-8 shows the device structure 10 in a corresponding cross-sectional view, taken along and through respective channel structures of the transistor structures 100, 100', 200. In the figures, the X- and Y-axes indicate first and second transverse horizontal directions, parallel to a main plane of a substrate 12 of the device structure 10. The Z-axis indicates a normal or vertical direction with respect to the substrate 12. Throughout the figures, like fill patterns will be used to for like materials, unless stated otherwise.

Fig. 1 shows the device structure 10 at an initial or starting stage of the method. Transistor structures 100, 100', 200 have been formed over the substrate 12. The substrate 102 may be a conventional semiconductor substrate suitable for CMOS processing. The substrate 102 may be a single-layered semiconductor substrate, for instance formed by a bulk substrate such as a Si substrate, a germanium (Ge) substrate or a silicon-germanium (SiGe) substrate. A multi-layered / composite substrate is also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The stacked transistor structure 100 defines a transistor structure being suitable to form a stacked transistor, comprising a bottom transistor and a top transistor, in particular a CFET. The stacked transistor structure 100 comprises a bottom channel structure 110 and a top channel structure 120 stacked on top of the bottom channel structure 110. Various features of the stacked transistor structure will in the following be discussed with reference to the stacked transistor structure 100. However, the description applies correspondingly to the further stacked transistor structure 100'.

The bottom and top channel structures 110, 120 comprises a respective number of channel layers 102, vertically stacked along the Z-direction. Each channel layer 102 extends as shown along the X-direction, between a respective pair of opposite ends. It is to be noted that the illustrated numbers of channel layers 102 are merely non-limiting examples, and the number of layers may be varied.

The channel layers 102 may be semiconductor layers formed of a channel material. The channel material may for instance be a SiGe material, such as Si (e.g. Si₁₋ₓGeₓ with x=0). The channel layers 102 may each be formed as nanosheets. For example, a nanosheet may have a thickness in a range of 5-15 nm, such as 10 nm, and a width in a range of 3-30 nm.

The stacked transistor structure 100 may as shown further comprise a dielectric separation layer 104 intermediate the bottom and top channel structures 110 and 120 (indicated by the brick shaped fill pattern). The dielectric separation layer may for example be formed of an oxide- or nitride-based material, for instance of SiO₂, SiN, SiC, SiCO, SiCN or SiBCN or combinations thereof. A dielectric separation layer may facilitate various process steps for forming a stacked transistor structure, in particular related to gate formation wherein the dielectric separation layer may facilitate providing gate stacks of different conductivity type at the bottom and top channel structures 110, 120. However, a dielectric separation layer may also be omitted wherein a gate structure may extend uninterrupted between the bottom and top channel structures 110, 120.

The stacked transistor structure 100 further comprises a gate structure 130 extending across the bottom and top channel structures 110, 120. A longitudinal dimension of the gate structure 130 is oriented in the Y-direction. The gate structure 130 comprises a gate stack formed on and surrounding the channel layers 102. The gate stack may comprise a gate dielectric layer, and one or more gate metal layers, such as at least one workfunction metal (WFM) and a gate fill metal. Suitable gate dielectric materials include for instance conventional a high-k dielectrics e.g. HfO₂, HfSiO, LaO, AlO or ZrO. Suitable WFMs include one or more effective WFMs such as n-type WFMs (e.g. TiAl or TiAlC) and/or p-type WFMs (e.g. TiN or TaN). Suitable gate fill metals include for instance W, Al, Co or Ru.

While Fig. 1 schematically shows the gate structure 130 with a same layer structure at the bottom and top channel structures 110, 120, it is to be noted that the gate structure 130 may comprise a bottom gate stack or bottom gate stack portion formed on the bottom channel structure 110 (e.g. below the dielectric separation layer 104) and a top gate stack or top gate stack portion formed on the top channel structure 120 (e.g. above the dielectric separation layer 104). This may be advantageous for forming a CFET, wherein the bottom and top transistor have different conductivity types. Accordingly, the bottom gate stack may be an N-type gate stack (for an N-type bottom transistor) and the top gate stack may be a P-type gate stack (for a P-type top transistor), or vice versa.

The gate structure 130 is provided with a gate cap 132, formed on top of the gate structure 130, thus capping the same. Suitable materials for the gate cap 132 include for instance SiN, SiC, SiCO, SiCN, SiBCN. Further, a gate spacer 134 is formed on and along respective opposite sidewalls of the gate structure 130. Suitable materials for the gate spacer 26 include for instance SiN, SiC, SiCO, SiCN or SiBCN, or combinations thereof. The gate spacer 134 may be formed of a different material than the gate cap 132 to facilitate opening of the gate cap 132 selectively to the gate spacer 134.

The stacked transistor structure 100 further comprises first and second bottom S/D structures 112a-b formed on the opposite ends of the channel layers 102 of the bottom channel structure 110, and first and second top S/D structures 122a-b formed on the opposite ends of the channel layers 102 of the top channel structure 120. The first bottom and top S/D structures 112a, 122a are formed at a first side of the gate structure 130. The second bottom and top S/D structures 112b, 122b are formed at a second side of the gate structure 130, opposite the first side.

The bottom and top S/D structures 112a-b, 122a-b may be formed as epitaxial (i.e. epitaxially grown) structures or bodies of doped semiconductor material (e.g. P-type or N-type Si or SiGe). In case the stacked transistor structure 100 is to form CFET, the bottom and top S/D structures 112a-b, 122a-b may be oppositely doped. For instance, the bottom S/D structures 112a-b may form N-type S/D structures (for an N-type bottom transistor) and the top S/D structures 122a-b may form P-type S/D structures stack (for an N-type bottom transistor), or vice versa. As shown, each one of the S/D structures 112a-b, 122a-b may be formed by merged S/D portions formed on respective channel layers 102. The S/D structures 112a-b, 122a-b are hence depicted as continuous bodies. As shown in Fig. 1, one or more of the S/D structures 112a-b, 122a-b may further merge with corresponding S/D structures of adjacent transistor structures, such as the further stacked transistor structure 100' or the non-stacked transistor structure 200 (described further below).

The stacked transistor structure 100 may further comprise inner spacers 106, formed between the gate structure 130 and the first and second bottom and top S/D structures 112a-b, 122a-b. Examples of inner spacer materials include dielectric materials, such as any of the materials mentioned in connection with the gate spacer 134. As per se is known to the skilled person, inner spacers may serve to facilitate subsequent process steps, such as a channel release step wherein the inner spacers may counteract etching of the S/D structures (e.g. 112a-b) during removal of sacrificial layers, discussed further below.

Still with reference to Fig. 1, first and second bottom S/D contacts 114a-b have been formed on the first and second bottom S/D structures 112a-b. Suitable contact metals include for instance fill metals such as W, Co, Ni, Mo, Ru, or combinations thereof, and optional preceding material layers such as a diffusion barrier layer (e.g. of TiN) and/or a seed layer to facilitate the subsequent deposition of the one or more fill metals.

A contact isolation layer 116a-b has further been formed on top of the first second bottom S/D contacts 114a-b, to define capped first and second bottom S/D contacts. Suitable contact capping materials include SiO₂, Si₃N₄, SiCO, SiOCN or combinations thereof.

The capped first and second bottom S/D contacts 114a-b have further been covered with an ILD layer 14. The ILD layer 14 further surrounds the gate structure 130, on either side. The ILD layer 14 may be formed of an insulating material, such as an oxide, e.g. SiO₂, or another conventional low-k dielectric suitable as interlayer dielectric.

The non-stacked transistor structure 200 defines a transistor structure being suitable to form a non-stacked transistor, thus comprising only a single channel structure 210 arranged at a same level over the substrate 12 as the bottom channel structure 110. The non-stacked transistor structure 200 may for instance be suitable to form a non-CMOS device such as a pass gate (also known as "pass transistor"). Some integrated circuits require a combination of CMOS and non-CMOS devices. Examples include, but are not limited to, SRAM bit cells, latches and flip-flops which include, in addition to CMOS devices (e.g. CMOS inverter pairs), a pass gate or pass transistor. In a CFET device with a common gate electrode, either the PFET or NFET will be on regardless of a high or low logic level gate voltage. A pass gate function may hence not be provided by a typical CFET. Accordingly, the non-stacked transistor structure 200 as shown in Fig. 1 allows forming of a non-CMOS device to supplement a CFET formed at the stacked transistor structure 100.

As shown in Fig. 1, the non-stacked transistor structure 200 substantially corresponds to the bottom transistor structure of the stacked transistor structure 100. Accordingly, the non-stacked transistor structure 200 comprises: the channel structure 210 comprising a number of vertically stacked channel layers 202 corresponding to the channel layers 102 (e.g. a same number of channel layers as the bottom channel structure 110), a (further) gate structure 230 corresponding to the gate structure 130, and first and second S/D structures 212a-b corresponding to the first and second bottom S/D structures 112a-b.

The gate structure 230 extends across the channel structure 210. The gate structure 230 is capped by a gate cap 232 corresponding to gate cap 132, and provided with a gate spacer 234 corresponding to the gate spacer 134. The first and second S/D structures 212a-b are formed on opposite ends of the channel structure 210, at a first and a second side respectively of the gate structure 230. The first and second S/D structures 212a-b may also be referred to as "bottom S/D structures" as they are formed at a same level over the substrate 12 as the first and second bottom S/D structures 112a-b.

As mentioned above, the second S/D structure 212b merges with the second bottom S/D structure 112b. The second bottom S/D contact 114b is hence formed also on the second S/D structure 212b. Further, a bottom S/D contact 214a is formed on the first S/D structure 212a at the first side of the gate structure 230. The bottom S/D contact 214a may in the following be referred to as the "third" bottom S/D contact 214a. The third bottom S/D contact 214a is like the bottom S/D contacts 214a-b capped by a contact isolation layer 216a to form a capped third bottom S/D contact 214a. The ILD layer 14 further covers the capped third bottom S/D contact 214a and surrounds the gate structure 230, on either side.

Each one of the channel structure 210 and the bottom channel structure 110 may as shown be separated from the substrate 12 by a bottom dielectric layer 101. Suitable materials for the bottom dielectric layer 101 include oxide and nitride materials, e.g. SiO₂, SiN, SiC, SiCO, SiCN, SiBCN or combinations thereof. A bottom dielectric layer 101 allows providing an improved isolation towards the substrate 12.

Fabrication of the device structure 10 as shown in Fig. 1 may proceed as follows:
Fin structures (e.g. a plurality of parallel fin structures extending in the X-direction) may be patterned in an initial layer stack comprising an initial bottom layer sub-stack (for forming the bottom channel structure 110 and the channel structure 210) and an initial top layer sub-stack (for forming the top channel structure 120). The bottom and top layer sub-stacks may each comprise a number of channel layers of a channel material and a number of sacrificial layers of a sacrificial material alternating the channel layers. The layers may be epitaxially grown using deposition techniques such as chemical vapor deposition (CVD). Conventional fin patterning techniques may be used, e.g. single patterning techniques such as lithography and etching ("litho-etch") or multiple-patterning techniques such as (litho-etch)^{x}, self-aligned double or quadruple patterning (SADP or SAQP).

The sacrificial material and the channel material may for instance be Si_{i-y}Ge_{y} and Si₁₋ₓGeₓ respectively, wherein 0 ≤ x < y. For example, y may be equal to or greater than x + d, where d ≥ 0.25. In one example, the sacrificial material may be SiGe_{0.25} and the channel material may be a Si. As per se is known in the art, a relative difference in Ge-content enables subsequent selective processing (e.g. selective etching) of the sacrificial layers and the channel layers. For example, a SiGe layer with a greater concentration of Ge than another Si or SiGe layer may be etched selectively (i.e. at a greater rate) using an HCl-based dry etch or an ammonia peroxide mixture (APM). Other appropriate etching processes (wet or dry) allowing selective etching of higher Ge-content SiGe layers with respect to lower Ge-content SiGe (or Si) layers are per se known in the art and may also be employed for this purpose.

The fin structures may subsequently be covered by a shallow-trench isolation (STI) oxide (e.g. SiO₂ deposited by CVD or physical vapor deposition (PVD)) which may be recessed, e.g. by chemical mechanical polishing (CMP) and/or etch back, to expose the fin structure(s) and form STI surrounding a respective base portion of the fin structures. The fin structures may then optionally be covered by an insulating liner layer, e.g. of SiN.

The fabrication may then proceed with sacrificial gate structure formation. A sacrificial gate layer (e.g. amorphous Si) may be deposited over the fin structure(s) (e.g. using CVD or PVD). Sacrificial gates (e.g. a plurality of parallel sacrificial gates extending in the Y-direction) may be patterned therein using single- or multiple-patterning techniques, as per se is known in the art. Gate spacers (e.g. gate spacers 134, 234) may subsequently be formed by depositing a gate spacer material (e.g. using ALD). The gate spacer material may then be etched anisotropically (e.g. top-down) to remove the gate spacer material from horizontally oriented surfaces of the device structure 10 such that the gate spacer material remains on the vertically oriented sidewalls of the sacrificial gates.

The fin structures may subsequently be recessed by etching back the fin structures in a top-down direction on either side of each sacrificial gate. Each fin structure may thereby be partitioned into a plurality of stacked transistor structures each comprising a respective bottom channel structure (e.g. 110, 210) of channel layers and sacrificial layers, and a respective top channel structure (e.g. 120) of channel layers and sacrificial layers. The etchback may proceed through fin structures, e.g. stopping at a level corresponding to an upper surface of the STI, and thus define ends or end surfaces of the respective sacrificial layers and channel layers on either side of each sacrificial gate.

The dielectric separation layer may be formed using a sacrificial layer replacement process, wherein an intermediate sacrificial layer of the fin structure (e.g. after fin patterning, such as prior to or subsequent to forming sacrificial gates) may be replaced with a dielectric material by removing the intermediate sacrificial layer in a selective etching process and refilling the thusly formed cavity in the fin structure with a dielectric using a conformal deposition process such as ALD. For example, in case of a Si/SiGe-based initial layer stack, the intermediate sacrificial layer may be formed of (e.g. of Si_{1-z}Ge_{z}, where z > y, such as z = y + d). The dielectric separation layer may also be formed by patterning fin structures in an initial layer stack wherein the initial top device sub-stack may be formed on a separate wafer and subsequently be transferred and bonded to an initial dielectric separation layer using a wafer transfer and bonding process. The initial dielectric separation layer then be patterned together with the bottom and top device sub-stacks to form the dielectric separation layer 104.

The bottom dielectric layers 101 may be formed for instance by replacing a bottom-most sacrificial layer of the fin structures with a dielectric layer. In a Si/SiGe-based fin structure, a bottom-most sacrificial layer may for instance be formed of SiGe with a higher Ge-content than the sacrificial layers, such that the bottom-most sacrificial layer may be removed employing a selective etching process. Cavities may thus be formed which may be filled with one or more dielectric material to form the bottom dielectric layers 101. The replacement process may be conducted, for instance after patterning the fin structures and prior to recessing the fin structures, or after recessing the fin structures.

The fabrication process may further comprise converting one or more stacked transistor structure into a respective non-stacked transistor structure. This may be achieved by removing the top channel structure or forming a cut through the top channel structure above each bottom channel structure where a non-stacked transistor structure is to be formed, such that the bottom channel structure remains (i.e. underneath the cut) to define the channel structure of the (non-stacked) transistor structure. A cut through a top channel structure may be formed by etching through each channel layer (and sacrificial layer) of the top channel structure, stopping above the bottom channel structure underneath. If a dielectric separation layer is present, the etching may for instance be stopped prior to or on the dielectric separation layer 104. The cut may for instance be formed after forming the sacrificial gates, prior to or subsequent to fin recess. However, non-stacked transistor structures may be provided also employing other techniques, such as by removing the initial top layer sub-stack along parts of the fin structures where non-stacked transistor structures are desired.

Prior to forming the bottom S/D structures, inner spacers (e.g. inner spacers 106) may be formed using an inner spacer formation process. An inner spacer formation process may comprise forming recesses using a lateral etch back (e.g. along the X- and negative X-directions) of the ends or end surfaces of each sacrificial layer from opposite sides of the respective sacrificial gates using an isotropic etching process (e.g. selective to the sacrificial material). Inner spacer material may be deposited with a thickness such that the recesses are pinched-off (i.e. closed) by the spacer material. The inner spacer material may for example be deposited using conformal deposition techniques such as ALD. Portions of inner spacer material deposited outside the recesses may subsequently be removed using a suitable etching process (anisotropic or isotropic, wet or dry) to expose end surfaces of the channel layers 104.

After inner spacer formation, the method may proceed with forming the bottom S/D structures on the bottom channel structures (e.g. 110) and on the channel structures of any non-stacked transistor structures (e.g. 210). The S/D structures may be formed, using an epitaxial process, on the ends or end surfaces of the respective channel layers of the channel structures. Prior to the S/D epitaxy, a temporary cover spacer may be formed to cover the end surfaces of the channel layers of the top channel structures (e.g. 120), to act as an epitaxy mask facilitating area selective epitaxy on the channel layers of the bottom channel structures. The cover spacer may be removed after the bottom S/D epitaxy is completed.

Subsequent to forming the S/D structures, an insulating material may be deposited (e.g. SiO₂ deposited by flowable-CVD) and recessed (e.g. by CMP and/or etch back) to form the ILD layer 14. Prior to forming the ILD layer 14, the bottom S/D structures may be provided with a dielectric contact etch stop layer (ESL), such as an ALD-deposited nitride- or carbide-based material

Bottom S/D contacts (e.g. 114a-b, 214a) may thereafter be formed by etching contact trenches in the ILD layer 14 (e.g. using a standard lithography and etching process). The contact trenches may be formed with a depth to expose at least an upper portion of the bottom S/D structures (e.g. 112a-b, 212a-b). To complete the contact trench formation, a separate etch step may be applied to open the contact ESL, if present on the bottom S/D structures (e.g. 112a-b, 212a-b). One or more contact metals may then be deposited on the bottom S/D structures and to fill the contact trenches. For instance, fill metal may be deposited for instance using CVD, PVD or plating. Deposition of the fill metal(s) may be preceded by conformal deposition (e.g. using ALD) of a diffusion barrier layer and/or a seed layer. After filling the contact trenches, overburden contact metal (i.e. contact metal deposited outside the contact trenches) may be removed using a planarization process comprising e.g. CMP and/or metal etch back. The contact metal may further be recessed in the contact trenches to form the bottom S/D contacts with a desired height. The bottom S/D contacts may then be covered with a contact isolation material, which may be etched back (e.g. employing an etch selective to the dielectric contact material) to form a contact isolation layer with a desired thickness, capping each bottom S/D contact (e.g. 116a-b and 216a on S/D contacts 114a-b, 214a). An insulating material (e.g. SiO₂) may then be deposited in the contact trenches, to cover the capped bottom S/D contacts (e.g. 114a-b, 214a) and restore the ILD layer 14.

Top S/D structures (e.g. 122a-b) may further be formed on the top channel structures (e.g. 120). The top S/D structures may for instance be formed subsequent to the bottom S/D contact formation. The top S/D structures may like the bottom S/D structures be formed in an epitaxial process. To form CFETs, the bottom and top S/D structures should be formed with opposite conductivity types. The top S/D structures may be formed by patterning S/D trenches in the ILD layer 14, along the ends of the channel layers of the top channel structures (e.g. 120). As may be appreciated, the trenches should be formed not to expose the bottom S/D structures or bottom S/D contacts. After completing the top S/D epitaxy, the S/D trenches may be re-filled with ILD to restore the ILD layer 14. The top S/D structures may additionally, like the bottom S/D structures, be provided with a dielectric contact ESL prior to depositing the ILD.

The fabrication process may further proceed with replacing the sacrificial gates with functional gate structures, employing a replacement metal gate (RMG) process. According to the RMG process, the sacrificial gates are removed to define gate trenches or gate cavities in the ILD layer surrounding the sacrificial gates (e.g. ILD layer 14), between the gate spacers (e.g. 134, 234). A gate structure may then be formed on each channel structure exposed in the respective gate trenches by depositing a gate stack therein. A gate dielectric and one or more WFMs may be deposited by ALD. Gate fill metal may be deposited to fille a remaining space of the gate trenches using CVD or PVD. Overburden gate stack material deposited outside the gate trenches may subsequently be removed using a planarization process (e.g. CMP). The gate stacks may thereafter be recessed to form final gate structures of a desired height. The gate structures may be covered with a gate capping materials, e.g. deposited by CVD or PVD, which may be subjected to a planarization process (e.g. CMP) to remove overburden capping material and form gate caps (e.g. 132 and 232).

A gate stack comprising bottom and top gate stacks of different conductivity types may be formed in a CMOS-RMG process. According to a CMOS-RMG process a first WFM (conformally deposited) may be removed selectively from the top channel structures using an isotropic metal etch process while masking the first WFM formed on the bottom channel structures using a block mask layer. A block mask layer may for instance be formed by depositing mask material in the gate trenches and etching back the mask material such that the first WFM on the top channel structures is exposed and remains covered on the bottom channel structures. The mask material may for instance be etched back to a level coinciding with the dielectric separation layer (e.g. 104). The mask material may be an organic material deposited using a CVD or spin-on process (e.g. an organic spin-on-layer such as SOC). In case a CMOS-RMG process is used, the bottom mask layer may be formed also to mask the first WFM deposited on the channel structure of the non-stacked transistor structures (e.g. channel structure 210 of transistor structure 200). After removing the bottom mask layer, a second WFM, or a stack of WFMs, may be deposited on the first WFM remaining on the bottom channel structures and on the gate dielectric layer on the top channel structures. The RMG structure formation may then proceed by depositing the gate fill metal.

A channel release process may further be performed within the RMG process, after removing the sacrificial gates and prior to depositing the gate stack. In the channel release process, the sacrificial layers (e.g. of SiGe) of the initial bottom and top channel structures are removed selectively to the channel layers (e.g. of Si). The sacrificial layers may be removed by etching the sacrificial material selectively to the channel material. A same type of etching process may be used for this step as during the forming of the recesses for the inner spacers. The channel layers may thus be released in the sense that upper and lower surfaces thereof may be exposed.

While in the fabrication example above, both the bottom and top channel structures are initially formed to comprise sacrificial layers, the method is applicable also to device layer stacks with other layer structures. For example, the bottom channel structures 110 and 210 and/or the top channel structures 120 may comprise only a single channel layer and no sacrificial layers. This structure may be useful for forming bottom and/or top devices with only a single channel layer and without a gate-all-around. In a bottom and/or device channel structure without sacrificial layers, inner spacers may be omitted, as would be understood by the skilled person.

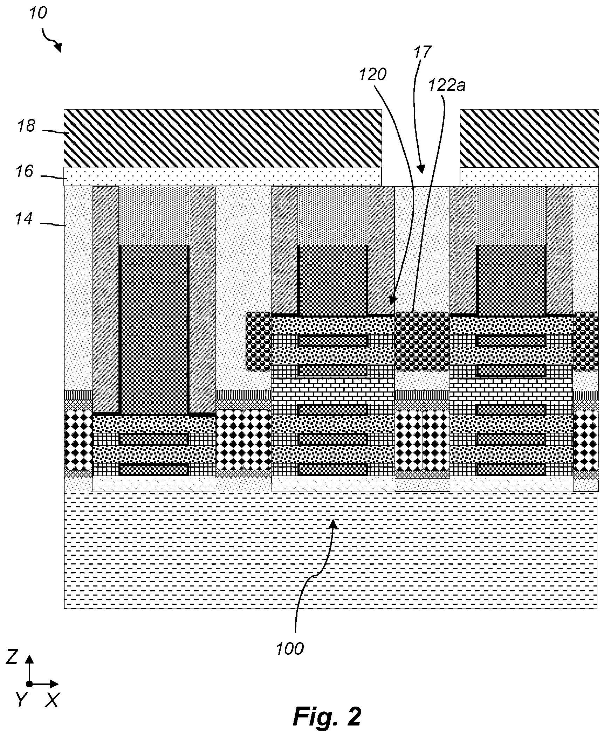

Fig. 2-3 illustrate steps of a first lithography and etching process to form a first contact trench 123a in the ILD layer 14, at a first side of the gate structure 130.

In Fig. 2, a hardmask layer 16 has been formed over the device structure 10, on top of the ILD layer 14 and the gate structures 130, 230. Suitable materials for the hardmask layer 16 include dielectric hardmask materials (e.g. SiN or AlN) and metal hardmask materials (e.g. TiN) deposited by CVD, PVD or ALD. A dual-hardmask layer 16 is also possible, such as a metal hardmask (e.g. TiN) on an oxide hardmask (e.g. SiO₂ deposited by plasma-enhanced CVD (PECVD) or ALD (PEALD)).The hardmask layer 16 has been patterned to define a first contact opening 17 exposing a portion of the ILD layer 14 at the first side of the gate structure 130 and overlying the first top S/D structure 122a. The hardmask layer 16 has been patterned using a lithographic layer stack as an etch mask, of which Fig. 2 shows a bottom mask layer 18 of the lithographic layer stack. The mask layer 18 may for instance be a spin-on-carbon (SOC) layer of a spin-on-glass (SOG)/SOC stack. In another example the mask layer 18 may be an amorphous carbon patterning film (APF) of a SiOC/ APF stack deposited by PECVD. After lithographically patterning an initial opening in a top resist layer of the lithographic layer stack, the initial opening has been transferred into the lithographic layer stack by etching, and eventually into the hard mask layer 16 to form the first contact opening 17.

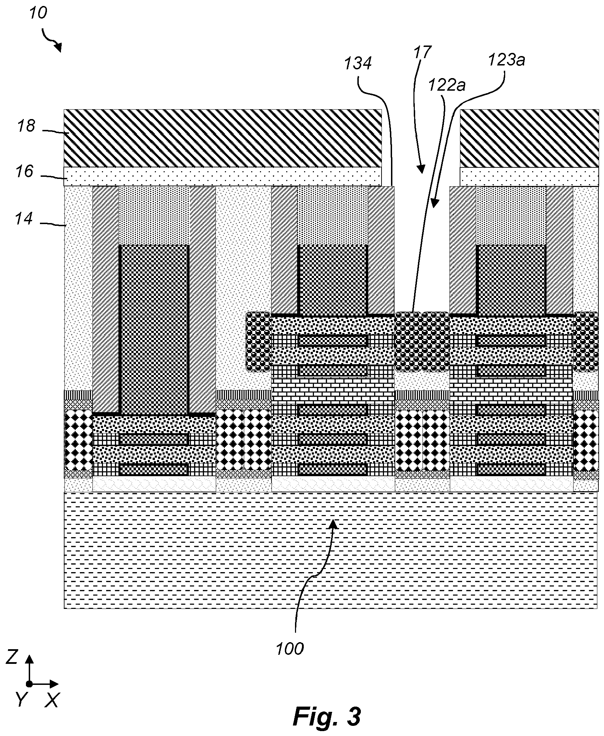

In Fig. 3, the first contact trench 123a has been formed by opening the ILD layer 14 by etching the ILD layer 14 via or from the first contact opening 17. The etching extends through (top-down) the ILD layer 14 and is stopped after the ILD layer 14 has been etched back to a level of the first top S/D structure 122a, and stopped prior to exposing the contact isolation layer 116a of the capped first bottom S/D contact 114a. In case the first top S/D structure 122a is provided with an ESL, a final etch stop to open the ESL may be performed to complete the formation of the first contact trench 123a and expose the first top S/D structure 122a therein. Any conventional etching process suitable for etching ILD material may be used. For instance, employing an anisotropic etching process enables forming of the first contact trench 123a while avoiding undercutting of the first hardmask layer 16.

The etching process may advantageously etch the ILD material selectively to the gate spacer material of the gate spacer 134, wherein the first contact trench 123a may be etched self-aligned to the gate structure 130 and gate spacer 134. It is to be noted that the particular depth of the trench etch depicted in Fig. 3 merely is an example, and the etching may be extended and stopped on the contact isolation layer 116a (thus using the contact isolation layer 116 as an etch stop layer).

Although not shown in Fig. 3, the opening of the hardmask layer 16 and/or the etching of the ILD layer 14 may at least partially consume the lithographic layer stack, including the mask layer 18. It is also possible to remove any remaining portions of the lithographic layer stack from the first hardmask layer 16 prior to etching the ILD layer 14, wherein the hardmask layer 16 on its own may be used as an etch mask when forming the first contact trench 123a. In any case, while forming the first contact trench 123a, the ILD layer 14 is masked at the second side of the gate structure 130 by at least the first hardmask layer 16.

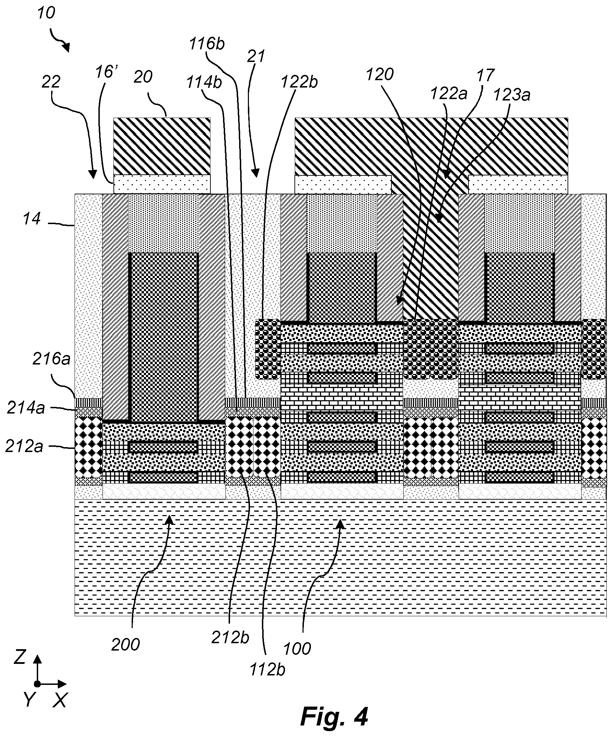

Fig. 4-6 illustrate steps of a second lithography and etching process to form a second contact trench 123b in the ILD layer 14, at a second side of the gate structure 130 of the stacked transistor structure 100, and further a third contact trench 223a, at the first side of the further gate structure 230 of the non-stacked transistor structure 200.

As shown in Fig. 4, the second lithography and etching process initially proceeds in a manner similar to the first lithography and etching process, in that the (once patterned) first hardmask layer 16 is patterned (again) to define a second contact opening 21 and a third contact opening 22. In Fig. 4 and onwards, reference sign 16' is used to distinguish the twice patterned first hardmask layer 16 from the once patterned first hardmask layer 16.

The second contact opening 21 exposes a portion of the ILD layer 14 at the second side of the gate structure 130 and is overlying the second top S/D structure 122b. The third contact opening 22 exposes a portion of the ILD layer 14 at the first side of the further gate structure 230 and is overlying the first S/D structure 212a. The second and third contact openings 21, 22 have been patterned using a second lithographic layer stack as an etch mask. Layer 20 denotes a bottom mask layer 20 of the second lithographic layer stack and may like the mask layer 18 be a SOC layer of a SOG/SOC stack, or an APF of a SiOC/APF stack. The mask layer 20 is deposited to fill the first contact opening 17 in the first hardmask layer 16 and the first contact trench 123a in the ILD layer 14.

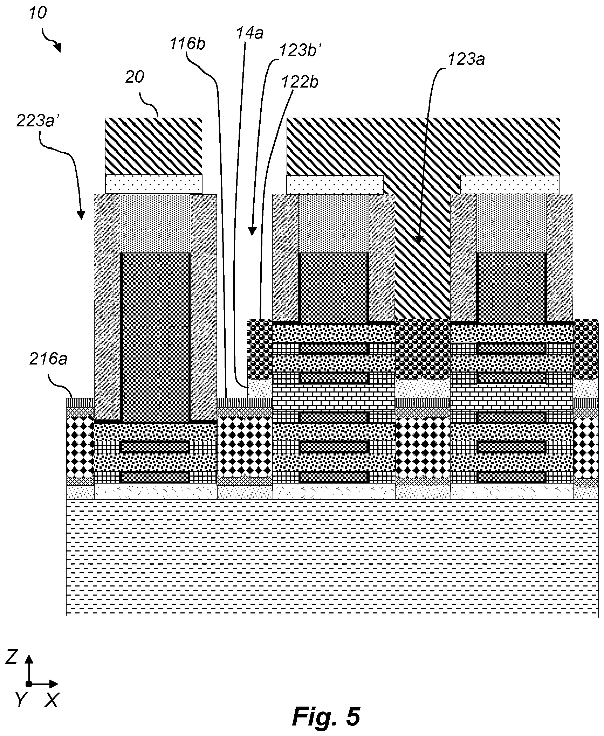

In Fig. 5 initial second and third contact trenches 123b', 223a' have been formed by opening the ILD layer 14 by etching the ILD layer 14 via or from the second and third contact openings 21, 22, respectively. The etching of the initial second contact trench 123b' extends through (top-down) the ILD layer 14 and is stopped on the contact isolation layer 116b of the capped second S/D bottom contact 114b. Correspondingly, the etching of the initial third contact trench 223a' extends through (top-down) the ILD layer 14 and is stopped on the contact isolation layer 216a of the capped third S/D contact 214a. The etching is conducted employing an anisotropic etching process etching the ILD layer 14 selectively to the contact isolation layers 116b and 216a.

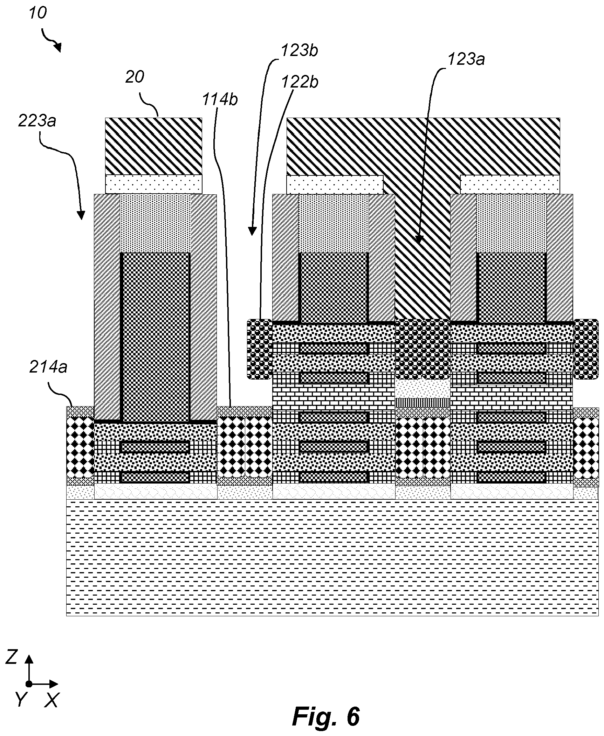

As shown in Fig. 5, as a result of the anisotropic top-down etching of the ILD layer 14 from the second contact opening 21, a portion 14a of the ILD layer 14 is shadowed or masked by the second top S/D structure 122b, and hence preserved in the initial second contact trench 123b'. In Fig. 6 the second contact trench 123b has been provided in its final form by opening the contact isolation layer 116b of the capped second bottom S/D contact 114b using an isotropic etching process. The isotropic etching process may thus as shown remove not only a portion of the contact isolation layer 116b exposed during the first anisotropic etch step ("first portion"), but further the ILD layer portion 14a and a portion of the contact isolation layer 116b underneath the ILD layer portion 14a. A comparably large surface area of the second bottom S/D contact 114b may hence exposed in the second contact trench 123b.

The isotropic etching process has further been applied in the initial third contact trench 223a' to form the final third contact trench 223a by opening the contact isolation layer 216a and thus exposing the third S/D contact 214a.

While forming the second and third contact trenches 123b, 223a, the first contact trench 123a and portions of the ILD layer 14 surrounding the first contact trench 123a at the first side of the gate structure 130 is masked by at least the mask layer 20 (and possibly further remaining layers of the second lithographic layer stack). Accordingly, the first top S/D structure 122a, the contact isolation layer 116a and any remaining portions of the ILD layer 14 within the first contact trench 123a, are masked by the mask layer 20 filling the first contact trench 123a. Further deepening of the first contact trench 123a and/or opening of the contact isolation layer 116 may hence be avoided.

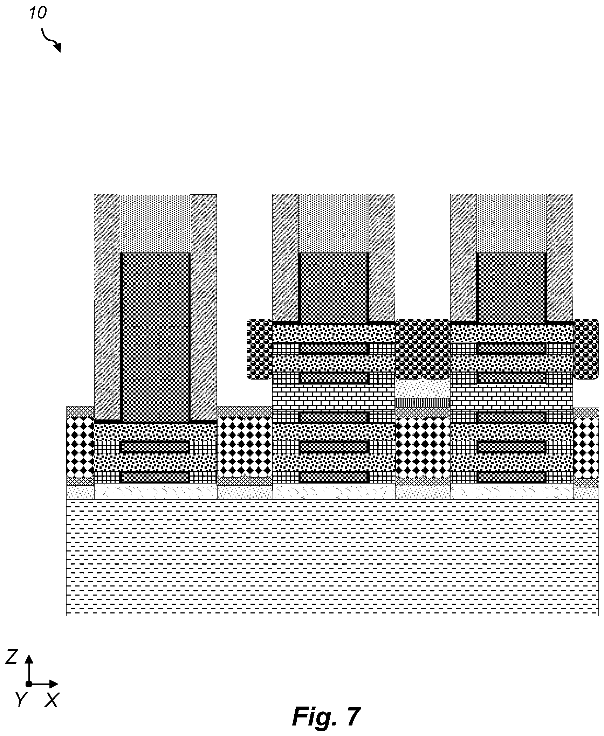

After forming the second and third contact trenches 123b, 223a, the (twice patterned) first hardmask layer 16' and any remaining portions of the second lithographic layer stack and the second mask layer 20 (if any) may be removed from the device structure 10 using one or more suitable removal chemistries, as needed. The resulting device structure 10 is shown in Fig. 7. It is also possible to remove the first hardmask layer 16' at a later stage, such as in connection with a planarization process applied to a top contact metal layer 24 discussed below.

As noted in connection with forming the first contact trench 123a, the anisotropic and isotropic etching processes used to form the second and third contact trenches 123b, 223a may advantageously etch the ILD material of the ILD layer 14 selectively to the gate spacer material of the gate spacers 134, 234, wherein the second and third contact trenches 123b, 223a may be etched self-aligned to the respective gate structures and gate spacers.

Although in the illustrated example, the contact isolation layers 116b, 216a are used as etch stop layers for the initial anisotropic etching step, it is also possible to use an etching chemistry which does not stop on the contact isolation layers 116b, 216a, but stops on the metal surface of the S/D contacts 114b, 214a. Hence, the contact isolation layers 116b, 216a may be opened already during the anisotropic etching, wherein the subsequent isotropic etching may remove remaining portions of the respective contact isolation layers 116b, 216a, in particular the aforementioned second portion of the contact isolation layers 116b shadowed by the second top S/D structure 122b.

According to the illustrated embodiment, a same first hardmask layer 16/16' is used when forming the first contact trench 123a and the second and third contact trenches 123b, 223a. Partial loss of the ILD layer 14 due to hardmask layer removal may hence be reduced as only the first hardmask layer 16 needs to be removed. However, it is also possible to remove the first hardmask layer 16 after forming the first contact trench 123a and form a second hardmask layer in its stead, in which second and third contact openings may be patterned in a corresponding manner. In this case, the first contact trench 123a may first be filled with a suitable temporary fill material (e.g. SOC), to provide the device structure 10 with a planar upper surface on which the second hardmask layer may be formed.

It is further an option to omit use of hardmask layers, wherein first, second and third contact trenches may be formed using only the first and second lithographic layer stacks formed directly on top of the ILD layer 14.

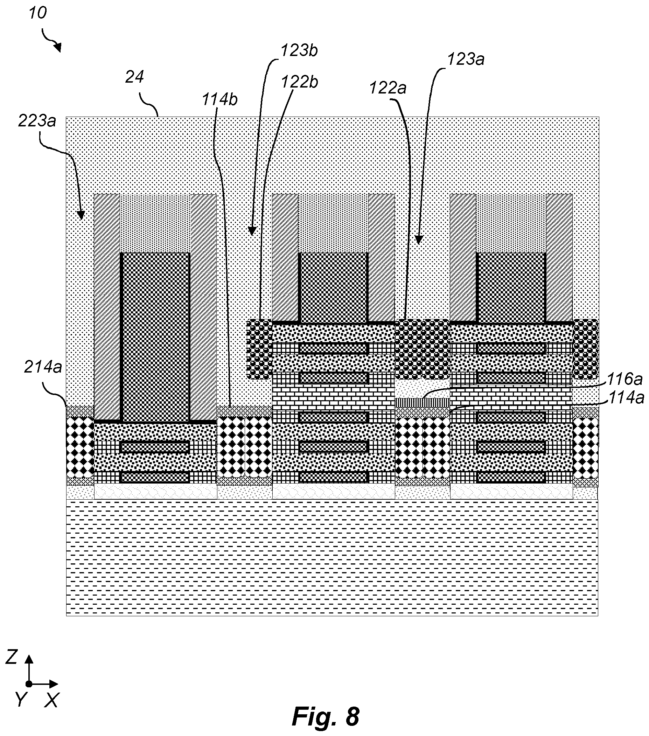

In Fig. 8, the first contact trench 123a and the second and third contact trenches 123b, 223a have been filled simultaneously with one or more contact metals to form a top contact metal layer 24. Any of the contact metals mentioned in connection with the first and second bottom S/D contacts 114a-b may be used. The top contact metal layer 24 is formed in contact with the second top S/D structure 122b and each one of the bottom S/D contacts 114b and 214a. The top contact metal layer 24 is however separated from the first bottom S/D contact 114a by at least the contact isolation layer 116a.

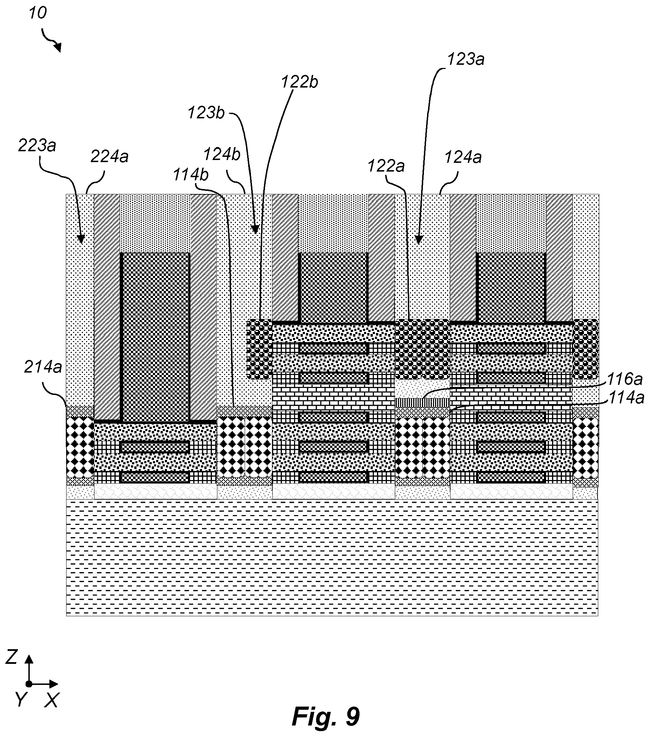

In Fig. 9, the top contact metal layer 24 has been subjected to a planarization process comprising e.g. CMP and/or metal etch back, to remove overburden contact metal and define separate top S/D contacts. More specifically, a first top S/D contact 124a is formed in the first contact trench 123a, in contact with the first top S/D structure 122a, over the contact isolation layer 116a of the capped first bottom S/D contact 114a. A second top S/D contact 124b is formed in the second contact trench 123b, in contact with and wrapping around the second top S/D structure 122b, and further in contact with the second bottom S/D contact 114b. A third top S/D contact 224a is formed in the third contact trench 223a, on the third bottom S/D contact 214a.

In the above the inventive concept has mainly been described with reference to a limited number of examples. However, as is readily appreciated by a person skilled in the art, other examples than the ones disclosed above are equally possible within the scope of the inventive concept, as defined by the appended claims.

For instance, in the above the method has been described with reference to a device layer structure 200 comprising a gate structure 130 comprising a functional gate stack, e.g. formed in an RMG process performed prior to forming the contact trenches and the top S/D contacts (a "RMG-first" approach). However, it is also possible to form the functional gate stack in an "RMG-last approach", where "last" indicates that the sacrificial gate structure is replaced after the top S/D contact formation. According to an RMG-last approach, the gate structures 130, 230 shown in the figures would correspond to sacrificial gate structures (e.g. of amorphous Si), and the gate caps 132, 232 would correspond to portions of a hardmask remaining from the sacrificial gate patterning.

## Claims

1. A method for forming a semiconductor device, comprising:
forming, over a substrate, a stacked transistor structure comprising: a bottom channel structure and a top channel structure stacked on top of the bottom channel structure, a gate structure extending across the bottom and top channel structures, a first and a second bottom source/drain (S/D) structure on the bottom channel structure, and a first and a second top S/D structure on the top channel structure, wherein the first bottom and top S/D structures are formed at a first side of the gate structure, and the second bottom and top S/D structures are formed at a second side of the gate structure opposite the first side;
forming a first and a second bottom S/D contact on the first and the second bottom S/D structures, respectively;
forming a contact isolation layer capping the first and second bottom S/D contacts to form capped first and second bottom S/D contacts, and covering the capped first and second bottom S/D contacts with an interlayer dielectric layer;
forming, at the first side of the gate structure, a first contact trench exposing the first top S/D structure over the capped first bottom S/D contact;
forming, at the second side of the gate structure, a second contact trench exposing the second bottom S/D contact and the second top S/D structure; and
forming a first top S/D contact in the first contact trench, in contact with the first top S/D structure, over the capped first bottom S/D contact, and a second top S/D contact in the second contact trench, in contact with the second top S/D structure and the second bottom S/D contact.

2. A method according to claim 1, wherein the first contact trench is formed while masking the interlayer dielectric layer at the second side of the gate structure, and wherein the second contact trench is formed subsequent to the first contact trench, while masking the first contact trench and the interlayer dielectric layer at the first side of the gate structure.

3. A method according to any one of claims 1-2, wherein the first contact trench is formed using a first lithography and etching process and the second contact trench is formed using a second lithography and etching process.

4. A method according to claim 3,
wherein the first lithography and etching process comprises patterning a first contact opening in a first hardmask layer formed over the stacked transistor structure, and opening the interlayer dielectric layer by etching via the first contact opening, and
wherein the second lithography and etching process comprises patterning a second contact opening in a second hardmask layer formed over the stacked transistor structure, and opening the interlayer dielectric layer and the contact isolation layer of the capped second bottom S/D contact by etching via the second contact opening.

5. A method according to claim 4, wherein the first hardmask layer and the second hardmask layer is a same hardmask layer.

6. A method according to any one of the preceding claims, wherein forming the first and second top S/D contacts comprises simultaneously depositing one or more metals in the first and the second contact trenches.

7. A method according to any one of the preceding claims, wherein forming the second contact trench comprises: opening the interlayer dielectric layer using an anisotropic etching process to expose the contact isolation layer of the capped second bottom S/D contact, and thereafter etching the contact isolation layer using an isotropic etching process, wherein the isotropic etching process removes a contact isolation layer portion remaining underneath the second top S/D structure after opening the interlayer dielectric layer.

8. A method according to claim 7, wherein the anisotropic etching process is stopped on the contact isolation layer or on the second bottom S/D contact.

9. A method according to claim 8, wherein the isotropic etching process further removes an interlayer dielectric layer portion remaining underneath the second top S/D structure after opening the interlayer dielectric layer.

10. A method according to any one of the preceding claims, further comprising forming a non-stacked transistor structure comprising: a channel structure located at a same level over the substrate as the bottom channel structure of the stacked transistor structure, a further gate structure extending across the channel structure, and a first and a second S/D structure on the channel structure, wherein the first S/D structure is formed at a first side of the further gate structure, and the second S/D structure is formed at a second side of the further gate structure opposite the first side of the further gate structure and merges with the second bottom S/D structure of the stacked transistor structure;
wherein the method further comprises:
forming a third bottom S/D contact on the first S/D structure of the non-stacked transistor structure;
forming the contact isolation layer to cap the third S/D bottom contact to form a third capped bottom S/D contact, and covering the third capped bottom S/D contact with the interlayer dielectric layer; and
forming the second bottom S/D contact on the second S/D structure of the non-stacked transistor structure.

11. A method according to claim 10, further comprising:
forming, at the first side of the further gate structure, a third contact trench exposing the third S/D contact, simultaneous to forming the second contact trench; and
forming a third top S/D contact in the third contact trench, on the third bottom S/D contact.

12. A method according to claim 10, wherein the first contact trench is formed while masking the interlayer dielectric layer at the second side of the gate structure, and at the first and second sides of the further gate structure, and wherein the second and third contact trenches are formed subsequent to the first contact trench, while masking the first contact trench and the interlayer dielectric layer at the first side of the gate structure.

13. A method according to any one of claims 11-12, wherein the first contact trench is formed using a first lithography and etching process and the second and third contact trenches are formed using a second lithography and etching process.

14. A method according to claim 13,
wherein the first lithography and etching process comprises patterning a first contact opening in a first hardmask layer formed over the stacked transistor structure, and opening the interlayer dielectric layer by etching via the first contact opening, and
wherein the second lithography and etching process comprises patterning a second contact opening and a third contact opening in a second hardmask layer formed over the stacked transistor structure, and opening the interlayer dielectric layer and the contact isolation layer of the capped second bottom S/D contact by etching via the second contact opening, and opening the interlayer dielectric layer and the contact isolation layer of the third capped S/D contact by etching via the third contact opening.

15. A method according to any one of claims 11-14, wherein forming the first, second and third top S/D contacts comprises simultaneously depositing one or more metals in the first, second and third contact trenches.
